# EUROPEAN PATENT SPECIFICATION

(11) **EP 3 207 561 B1**
(45) Date of publication and mention of the grant of the patent: **17.05.2023**
(21) Application number: 15850880.4
(22) Date of filing: 13.10.2015
(51) Int. Cl.: H01L 23/373, H01L 23/42, H01L 33/64, C01B 32/16, C01B 32/162

(54) **CARBON NANOTUBES DISPOSED ON METAL SUBSTRATES WITH ONE OR MORE CAVITIES**
AUF METALLSUBSTRATEN ABGESCHIEDENE KOHLENSTOFFNANORÖHRE MIT EINER ODER MEHREREN HOHLRÄUMEN
NANOTUBES DE CARBONE DISPOSES SUR SUBSTRATS METTALIQUES AVEC UNE OU PLUSIEURS CAVITE(S)

(30) Priority: 13.10.2014 US 201462063286 P
(43) Date of publication of application: 23.08.2017
(73) Proprietor: Ntherma Corporation, Fremont, CA 94538 (US)
(72) Inventor: NGUYEN, Cattien, V., San Jose, CA 95127 (US); BE, Van Vo, Santa Clara, CA 95054 (US)
(74) Representative: Hepworth Browne
(86) International application number: PCT/US2015/055177
(87) International publication number: WO 2016/061004

(56) References cited:
- WO-A2-2006/127208
- US-A1- 2005 092 464
- US-A1- 2006 071 334
- US-A1- 2007 059 864
- US-A1- 2008 003 801
- US-A1- 2008 224 301
- US-A1- 2010 112 828
- US-A1- 2011 198 059

## Description

### FIELD

Provided herein are carbon nanotubes disposed on a metal substrate containing one or more cavities, a method of fabricating the metal substrate and an an apparatus comprising the metal substrate.

### BACKGROUND

Thermal interface materials may be used for example, in microelectronic devices, light emitting diode (LED) devices, power electronics and batteries. The complexity of modem devices requires multiple-levels of integration and heat dissipation is an increasingly critical issue as integrated circuits reach increasingly infinitesimal size. Heat sinks, which function as heat spreaders, are used to transfer heat from the functional devices to the periphery of the packaging area. The poor heat conductivity of air requires thermal interface materials in conductive contact with functional devices and a heat sink, to efficiently transfer heat to the heat sink from the functional devices.

Although, inherent thermal conductivity is of critical importance other parameters need to be optimized in design of a thermal interface material. A thermal interface material should be mechanically flexible to maximize the contact area between the functional devices and the thermal interface material and the thermal interface material and the heat sink. Ideally, the thermal interface material conforms to the surface morphology of both the functional devices and heat sink.

Mechanical strength and resistance to physical cracking during temperature cycling are also advantageous properties of a thermal interface material. Thermal interface materials of low thermal expansion coefficient are highly desirable to avoid significant physical deformation during temperature cycling. Excessive physical deformation of the thermal interface material can cause damage to the functional devices in combination. Finally, thermal stability at the temperature regime of the functional devices is essential to avoid thermal-chemical degradation of the material and properties of the thermal interface material.

Accordingly, what is needed are novel thermal interface materials with superior mechanical strength which are resistant to physical cracking, low thermal expansion coefficient and thermal stability at the operating temperature of the functional device(s).

WO 2006/127208 discloses a heat-conducting medium for placement between a heat source and heat sink to facilitate transfer of heat from the source to the sink is provided. The heat- conducting medium can include a disk having relatively high thermal conductivity and heat spreading characteristics. The heat-conducting medium also includes a first recessed surface and an opposing second recessed surface. Extending from within each recessed surface is an array of heat conducting bristles to provide a plurality of contact points to the heat source and heat sink to aid in the transfer of heat. The recessed surfaces may be defined by a rim positioned circumferentially about the disk. The presence of the rim about each recessed surface acts to minimize the amount of pressure that may be exerted by the heat sink and the heat source against the bristles. A method for manufacturing the heat-conducting medium is also provided.

US 2008/224301 discloses a lead structure for a semiconductor component including: external leads for external connections outside a plastic housing composition, internal leads for electrical connections within the plastic housing composition, and a chip mounting island composed of the lead material.

US 2006/071334 discloses a semiconductor device using a carbon nanotube structure, which reduces an electric resistance and a thermal resistance by increasing a density of the carbon nanotubes.

US 2010/112828 discloses a carbon nanotube contact structure used for making pressure connections to a DUT.

US 2005/092464 discloses a heat sink (11) including a base (12), a plurality of fins (14) extending from a first surface of the base, and a plurality of carbon nanotubes (18) formed on an opposite second surface (16) of the base.

### SUMMARY

The present invention satisfies these and other needs by providing, in one aspect, a metal substrate according to claim 1.

In another aspect, a method of fabricating the metal substrate of the invention according to claim 3 is provided.

In still another aspect, an apparatus is provided according to claim 4.

### BRIEF DESCRIPTION OF THE FIGURES

Fig. 1 illustrates an exemplary flowchart for fabricating carbon nanotubes on a metal substrate including one or more cavities, where the cavities are introduced in the metal substrate prior to catalyst deposition;
Fig 2 illustrates an exemplary flowchart for fabricating carbon nanotubes on a metal substrate including one or more cavities, where the cavities are introduced in the metal substrate after catalyst deposition;
Fig. 3 illustrates an exemplary flowchart for fabricating carbon nanotubes on a metal substrate including one or more cavities, where catalyst deposition is not required;
Fig. 4 illustrates a metal substrate with a thickness t;
Fig. 5 illustrates a metal substrate with one or more cavities with a diameter d and a cavity-to-cavity separation D;
Fig. 6 illustrates deposition of carbon nanotubes on a metal substrate with one or more cavities, where the carbon nanotubes are vertically aligned with respect to the metal substrate surface and are deposited on the portion of the metal substrate without cavities.
Fig. 7 illustrates a cross-section of vertically aligned carbon nanotubes deposited on both sides of a metal substrate including one or more cavities, where the carbon nanotubes have lower density in areas around the cavity edges.
Fig. 8 illustrates an embodiment of an apparatus which includes a device, a heat sink and a thermal interface material. In the depicted embodiment, the thermal interface material, includes vertically aligned carbon nanotubes disposed on both side of a metal substrate including cavities. The thermal interface material is in conductive contact with the device and the heat sink and dissipates heat from the device to the heat sink; and
Fig. 9 illustrates another embodiment of an apparatus which includes a device, a heat sink and a thermal interface material. The thermal interface material, includes vertically aligned carbon nanotubes disposed on both side of a metal substrate including cavities. The carbon nanotube density is lower at the edges of the cavities. The thermal interface material is in conductive contact with the device and the heat sink and dissipates heat from the device to the heat sink;

### DETAILED DESCRIPTION

### Definitions

Unless defined otherwise, all technical and scientific terms used herein have the same meaning as is commonly understood by one of ordinary skill in the art to which this invention belongs. In the event that there is a plurality of definitions for a term herein, those in this section prevail unless stated otherwise.

As used herein "carbon nanotubes" refer to allotropes of carbon with a cylindrical structure. Carbon nanotubes may have defects such as inclusion of C5 and/or C7 ring structures, such that the carbon nanotube is not straight; and may have contain coiled structures; and may contain randomly distributed defected sites in the C-C bonding arrangement. Carbon nanotubes may contain one or more concentric cylindrical layers.

As used herein "catalysts" or "metal catalysts" refer to a metal or a combination of metals such as Fe, Ni, Co, Cu, Au, *etc.* that are used in the breakdown of hydrocarbon gases and aid in the formation of carbon nanotubes by chemical vapor deposition process.

As used herein "chemical vapor deposition" refers to plasma-enhanced chemical vapor deposition or thermal chemical vapor deposition.

As used herein "plasma-enhanced chemical vapor deposition" refers to the use of plasma (*e*.*g*., glow discharge) to transform a hydrocarbon gas mixture into excited species which deposit carbon nanotubes on a surface.

As used herein "thermal chemical vapor deposition" refers to the thermal decomposition of hydrocarbon vapor in the presence of a catalyst which may be used to deposit carbon nanotubes on a surface.

As used herein "physical vapor deposition" refers to vacuum deposition methods used to deposit thin films by condensation of a vaporized of desired film material onto film materials and includes techniques such as cathodic arc deposition, electron beam deposition, evaporative deposition, pulsed laser deposition and sputter deposition.

As used herein "thermal interface material" refers to a material that conducts heat from functional device(s) to a heat sink.

As used herein "functional device(s)" refers to any device(s ) which generate heat in the course of operation. Examples of functional devices include microelectronics computer processing units, microelectronics memory devices, light emitting diodes, a battery, a battery systems, power supplies, *etc.*

As used herein "heat sink" refers to a block of metal, with elevated surface area, which may be generated by complex structure, which can spread heat and dissipate heat by convection.

Carbon nanotubes are a relatively new material with exceptional physical properties, such as superior current carrying capacity, high thermal conductivity, good mechanical strength, and large surface area, which are advantageous in a number of applications. Carbon nanotubes possess exceptional thermal conductivity with a value as high as 3000 W/mK which is only lower than the thermal conductivity of diamond. Carbon nanotubes are mechanically strong and thermally stable above 400°C under atmospheric conditions. Carbon nanotubes have reversible mechanical flexibility particularly when vertically aligned. Accordingly, carbon nanotubes are able to mechanically conform to different surface morphologies because of this intrinsic flexibility. Additionally, carbon nanotubes have a low thermal expansion coefficient and retain flexibility in confined conditions under elevated temperatures.

Economically providing carbon nanotubes, in a controlled manner with practical integration and/or packaging are essential to implementing many potential carbon nanotube technologies. A compelling application of carbon nanotubes is incorporation into thermal interface materials.

In some embodiments, the one or more cavities are an aperture which breaches the substance. In some embodiments, the one or more cavities are a random shape. In other embodiments, the one or more cavities are a circle, triangle, square, pentagon, hexagon, heptagon, octagon or combinations thereof.

In some embodiments, the one or more cavities are randomly dispersed on the metal substrate. In some embodiments, the one or more cavities are regularly dispersed on the metal substrate. In still other embodiments, the one or more cavities comprise a patterned array on the metal substrate.

In some embodiments, the one or more cavities have an approximate width of between about 10 µm and about 10 cm. In other embodiments, the one or more cavities have an approximate width of between about 1 cm and about 10 cm. In still other embodiments, the one or more cavities have an approximate width of between about 1 mm and about 10 cm. In still other embodiments, the one or more cavities have an approximate width of between about 100 µm and about 10 cm. In still other embodiments, the one or more cavities have an approximate width of between about 10 µm and about 100 µm. In still other embodiments, the one or more cavities have an approximate width of between about 10 µm and about 1 mm. In still other embodiments, the one or more cavities have an approximate width of between about 10 µm and about 1 cm.

In some embodiments, the cavities in the array are separated by an approximate width of between about 10 µm and about 10 cm. In other embodiments, the cavities in the array are separated by an approximate width of between about 1 cm and about 10 cm. In still other embodiments, the cavities in the array are separated by an approximate width of between about1 mm and about 10 cm. In still other embodiments, the cavities in the array are separated by an approximate width of between about 100 µm and about 10 cm. In still other embodiments, the cavities in the array are separated by an approximate width of between about 10 µm and about 100 µm. In still other embodiments, the cavities in the array are separated by an approximate width of between about 10 µm and about 1 mm. In still other embodiments, the cavities in the array are separated by an approximate width of between about10 µm and about 1 cm.

It should be noted that all possible combinations of cavity separations and cavity widths with are operationally feasible are envisaged in the present invention.

In some embodiments, the carbon nanotubes are randomly aligned. In other embodiments, the carbon nanotubes are vertically aligned. In still other embodiments, the aerial density of the carbon nanotubes between about 2 mg/cm² and about 1 mg/cm². In still other embodiments, the density of the carbon nanotubes between about 2 mg/cm² and about 0.2 mg/cm².

In some embodiments, the density of carbon nanotubes disposed at the cavity edges is lower than the bulk density of the carbon nanotubes disposed on the metal surface. In other embodiments, the density of carbon nanotubes disposed at the cavity edges is less than about 95% of the bulk density of the carbon nanotubes disposed on the metal surface. In other embodiments, the density of carbon nanotubes disposed at the cavity edges is less than about 90% of the bulk density of the carbon nanotubes disposed on the metal surface. In other embodiments, the density of carbon nanotubes disposed at the cavity edges is less than about 95% of the bulk density of the carbon nanotubes disposed on the metal surface. In other embodiments, the density of carbon nanotubes disposed at the cavity edges is less than about 70% of the bulk density of the carbon nanotubes disposed on the metal surface. In other embodiments, the density of carbon nanotubes disposed at the cavity edges is less than about 95% of the bulk density of the carbon nanotubes disposed on the metal surface. In other embodiments, the density of carbon nanotubes disposed at the cavity edges is less than about 50% of the bulk density of the carbon nanotubes disposed on the metal surface. In other embodiments, the density of carbon nanotubes disposed at the cavity edges is less than about 95% of the bulk density of the carbon nanotubes disposed on the metal surface. In other embodiments, the density of carbon nanotubes disposed at the cavity edges is less than about 10% of the bulk density of the carbon nanotubes disposed on the metal surface.

In some embodiments, the density of carbon nanotubes disposed at the cavity edges is less than about 95% of the bulk density of the carbon nanotubes disposed on the metal surface. In other embodiments, the density of carbon nanotubes disposed at the cavity edges is less than about 90% of the bulk density of the carbon nanotubes disposed on the metal surface.

In some embodiments, vertically aligned carbon nanotubes have a thermal conductivity of greater than about 50 W/mK. In other embodiments, vertically aligned carbon nanotubes have a thermal conductivity of greater than about 70 W/mK.

In some embodiments, vertically aligned carbon nanotubes comprising a patterned array have a thermal conductivity of greater than about 50 W/mK. In other embodiments, vertically aligned carbon nanotubes comprising a patterned array have a thermal conductivity of greater than about 70 W/mK. In still other embodiments, vertically aligned carbon nanotubes comprising a patterned array have a thermal conductivity of greater than about 100 W/mK.

In some embodiments, the thickness of the vertically aligned carbon nanotubes is between than about 100 µm and about 500 µm. In other embodiments, the thickness of the vertically aligned carbon nanotubes is less than about 100 µm.

In some embodiments, carbon nanotubes are disposed on two opposing sides of the metal substrate. In other embodiments, carbon nanotubes are disposed on two sides of the metal substrate. In still other embodiments, carbon nanotubes are disposed on three sides of the metal substrate. In still other embodiments, carbon nanotubes are disposed on all sides of the metal substrate.

In some embodiments, the thickness of the metal substrate is between about 0.05 µm and about 100 cm. In other embodiments, the thickness of the metal substrate is between about 0.05 mm and about 5 mm. In still other embodiments, the thickness of the metal substrate is between about 0.1 mm and about 2.5 mm. In still other embodiments, the thickness of the metal substrate is between about 0.5 mm and about 1.5 mm. In still other embodiments, the thickness of the metal substrate is between about 1 mm and about 5 mm. In still other embodiments, the thickness of the metal substrate is between about 0.05 mm and about 1 mm. In still other embodiments, the thickness of the metal substrate is between about 0.05 mm and about 0.5 mm. In still other embodiments, the thickness of the metal substrate is between about 0.5 mm and about 1 mm. In still other embodiments, the thickness of the metal substrate is between about 1 mm and about 2.5 mm. In still other embodiments, the thickness of the metal substrate is between about 2.5 mm and about 5 mm. In still other embodiments, the thickness of the metal substrate is between about 100 µm and about 5 mm. In still other embodiments, the thickness of the metal substrate is between about 10 µm and about 5 mm.

In still other embodiments, the thickness of the metal substrate is greater than 100 µm.

In still other embodiments, the thickness of the metal substrate is less than 100 µm.

In some embodiments, the metal substrate is an alloy of two or more of iron, nickel, cobalt, copper, chromium, aluminum, gold and combinations thereof. In other embodiments, the metal substrate is an alloy of two or more of iron, nickel, cobalt, copper, gold and combinations thereof.

In some embodiments, the metal substrate is high temperature metal alloy. In other embodiments, the metal substrate is stainless steel. In still other embodiments, the metal substrate is a high temperature metal alloy on which a catalyst film is deposited for growing carbon nanotubes. In still other embodiments, the metal substrate is stainless steel on which a catalyst film is deposited for growing carbon nanotubes.

In some embodiments, the metal substrate is a metal or combination of metals which are thermally stable at greater than 500°C. In other embodiments, the metal substrate is a metal or combination of metals which are thermally stable at greater than 600°C. In still other embodiments, the metal substrate is a metal or combination of metals which are thermally stable at greater than 700°C. In some of the above embodiments, the combination of metals is stainless steel.

In some embodiments, the metal substrate has a thickness of less than about 100 µm and a surface root mean square roughness of less than about 250 nm. In some embodiments, the metal substrate has a thickness of greater than about 100 µm and a surface root mean square roughness of less than about 250 nm. In still other embodiments, the metal substrate has a thickness of less than about 100 µm and a surface root mean square roughness of less than about 250 nm and includes iron, nickel, cobalt, copper, gold or combinations thereof. In still other embodiments, the metal substrate has a thickness of greater than about 100 µm and a surface root mean square roughness of less than about 250 nm and includes iron, nickel, cobalt, copper, gold or combinations thereof. In still other embodiments, the metal substrate has a thickness of less than about 100 µm and a surface root mean square roughness of less than about 250 nm and includes a catalyst film. In still other embodiments, the metal substrate has a thickness of greater than about 100 µm and a surface root mean square roughness of less than about 250 nm and includes a catalyst film. In some of the above embodiments, the root mean square roughness is less than about 100 nm.

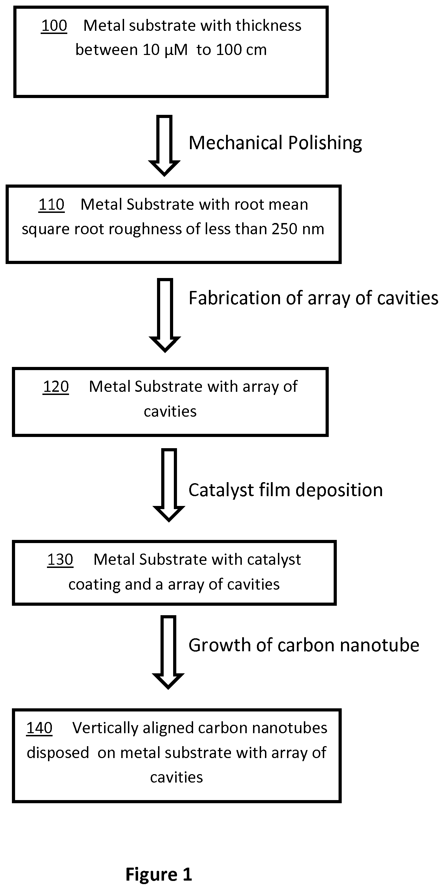

Referring now to Fig. 1, one embodiment of a method of fabricating a substance including carbon nanotubes disposed on at least one side of a metal substrate incorporating one or more cavities is illustrated. A metal substrate with a thickness between 10 µm and 100 cm is provided at **100.** Mechanical polishing, which can be accomplished by a variety of methods know to the skilled artisan then provides a metal substrate with a root mean square roughness of less than about 250 nm at **110** which is used to prepare a metal substrate including an array of cavities at **120.** Then, deposition of a catalyst film yields a metal substrate with a catalyst coating which includes an array of cavities at **130.** Finally, carbon nanotubes are grown on the metal substrate to provide vertically aligned carbon nanotubes disposed on a metal substrate with an array of cavities at **140.**

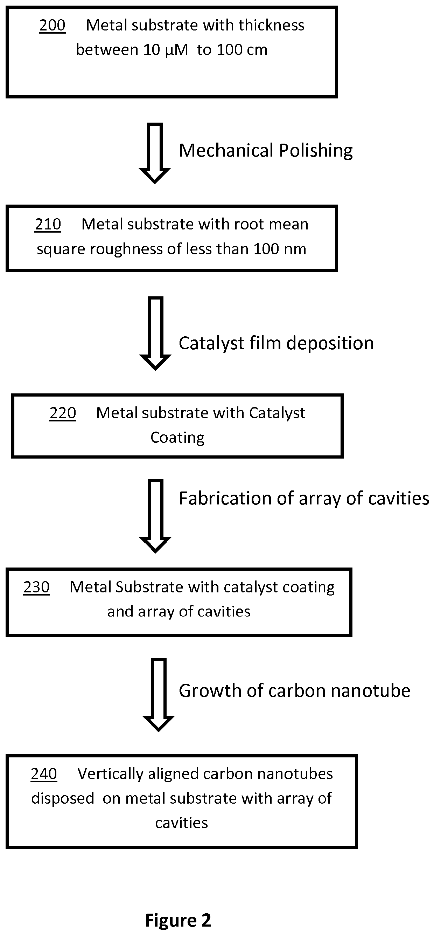

Referring now to Fig. 2, another embodiment of a method of fabricating a substance including carbon nanotubes disposed on at least one side of a metal substrate incorporating one or more cavities is illustrated. A metal substrate with a thickness between 10 µm and 100 cm is provided at **200.** Mechanical polishing, which can be accomplished by a variety of methods know to the skilled artisan then provides a metal substrate with a root mean square roughness of less than about 250 nm at **210.** Then deposition of a catalyst film yields a metal substrate with a catalyst coating at **220** which is used to fabricate an array of cavities at **230.** Finally, carbon nanotubes are grown on the metal substrate to provide vertically aligned carbon nanotubes disposed on a metal substrate with an array of cavities at **240.**

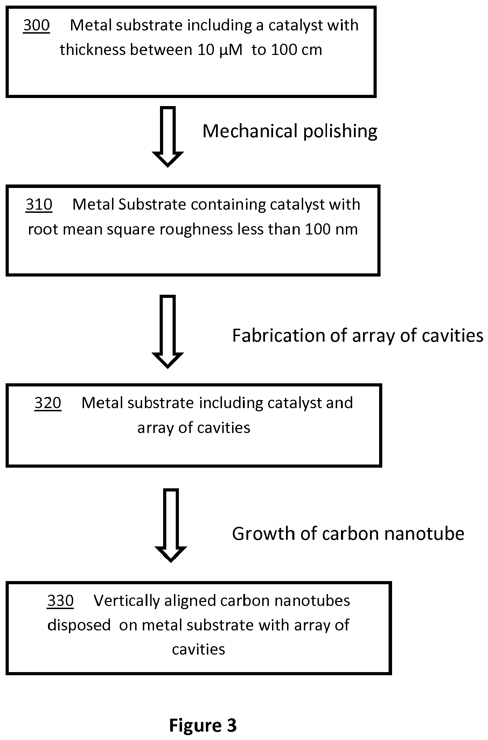

Referring now to Fig. 3, another embodiment of a method of fabricating a substance including carbon nanotubes disposed on at least one side of a metal substrate incorporating one or more cavities is illustrated. A metal substrate including a catalyst with a thickness between 10 µm and 100 cm is provided at **300.** Mechanical polishing, which can be accomplished by a variety of methods know to the skilled artisan then provides a metal substrate with a root mean square roughness of less than about 250 nm at **310** which is used to fabricate an array of cavities at **320.** Finally, carbon nanotubes are grown on the metal substrate to provide vertically aligned carbon nanotubes disposed on a metal substrate with an array of cavities at **330.**

In some of the above embodiments, the catalyst forms a layer on the metal substrate.

In some of the above embodiments, solution deposition techniques are used to deposit the catalyst. In other embodiments, solution deposition techniques include solution dipping, spraying, ink jet and print screening.

In some of the above embodiments, physical deposition techniques are used to deposit the catalyst. In other embodiments, physical deposition techniques include ion beam sputtering, electron beam deposition, evaporative metal heating and pulsed laser deposition.

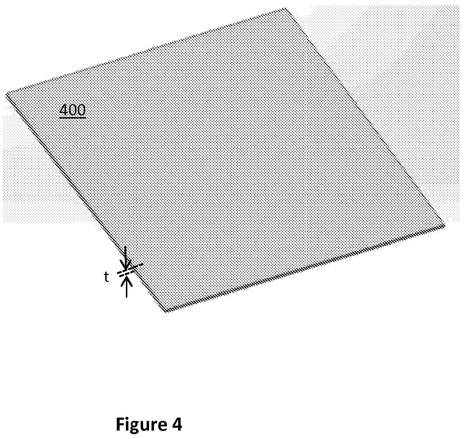

Referring now to Fig. 4, one embodiment of a metal substrate **400** with a thickness t is illustrated. The metal substrate can include any of the metals described above and can be any thickness described above.

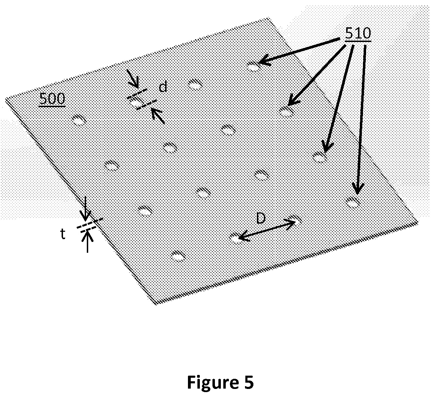

Fig. 5 illustrates one embodiment of a metal substrate **500** which includes patterned array of cavities **510.** In some embodiments, the metal substrate **500** includes a 2 x 2 array of cavities **510.** In other embodiments, the metal substrate **500** includes a array of cavities **510** greater than 2 x 2. In some embodiments, the cavities 510 are in a regular pattern. In other embodiments, the cavities **510** are in a random pattern. The cavities can have any geometry or combination of geometries previously described above. In some embodiments, the width of cavities **d** has any of the dimensions previously described above. In some embodiments, the N x N array of cavities **510** has a separation D with any of the distances described above.

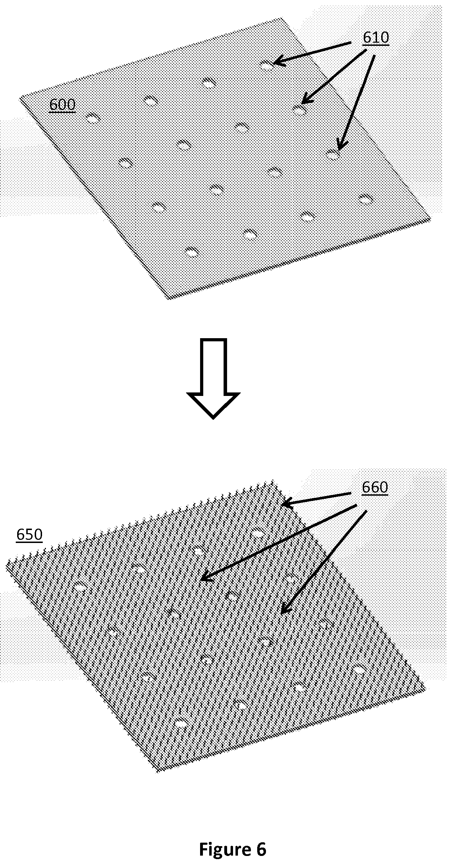

Fig. 6 illustrates one embodiment of carbon nanotube **660** deposition on a metal substrate **600** with cavities **610.** The carbon nanotubes **660** are vertically aligned with respect to the metal substrate surface **650** and are deposited on the metal substrate **650** without cavities **610.**

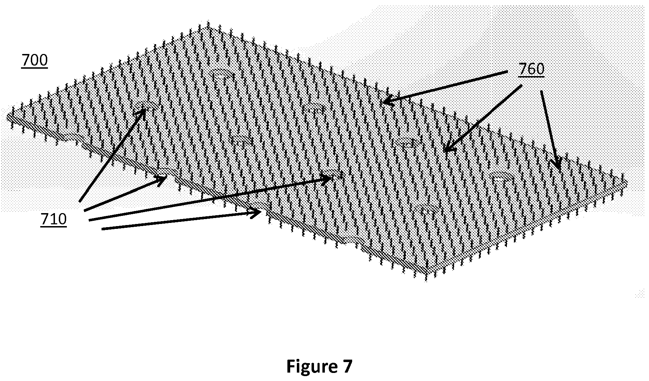

Fig. 7 illustrates one embodiment of vertically aligned carbon nanotubes **760** deposited on both sides of metal substrate**700** which includes cavities **710,** where the carbon nanotubes have lower density in areas around the edges of cavity **710.**

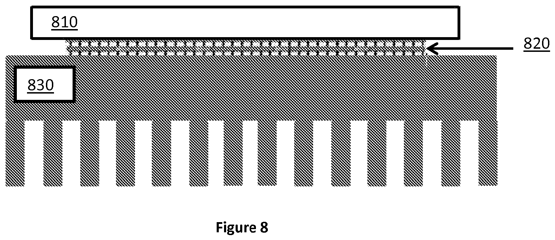

Fig. 8 illustrates one embodiment of an apparatus which includes a device **810**, a heat sink **830** and a thermal interface material **820.** The thermal interface material **820,** includes vertically aligned carbon nanotubes disposed on both side of a metal substrate which includes cavities. The thermal interface material **820** is in conductive contact with device **810** and heat sink **830** and conducts heat from device **810** to heat sink **830.**

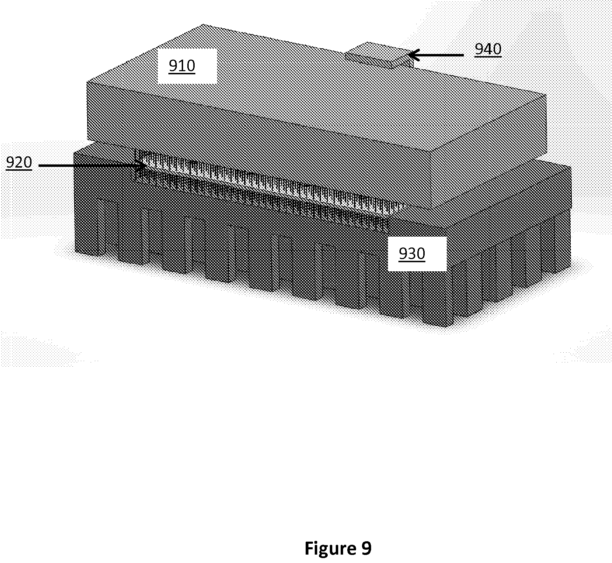

Fig. 9 illustrates another embodiment of an apparatus which includes a device **910,** a heat sink **930** a thermal interface material **920** and a clamp **940** which secures. The thermal interface material **920** includes vertically aligned carbon nanotubes disposed on both side of a metal substrate which includes cavities. The carbon nanotube density is lower at the edges of the cavities. The thermal interface material **920** is in conductive contact with device **910** and heat sink **930** and conducts heat from device **910** to heat sink **930.**

## Claims

1. A metal substrate having carbon nanotubes disposed on two opposing sides thereof, wherein the metal substrate includes one or more cavities and is comprised of iron, nickel, aluminum, cobalt, copper, chromium, gold and combinations thereof, **characterized in that** the metal substrate has a root mean square roughness of less than 250 µm.

2. The metal substrate of Claim 1, wherein the one or more cavities comprise an aperture breaching the metal substrate.

3. A method of fabricating the metal substrate of Claim 1, comprising:
forming one or more cavities in the metal substrate;
and depositing carbon nanotubes on opposing sides of the metal substrate.

4. An apparatus comprising:
a device;
a heat sink; and
the metal substrate of Claim 1 disposed between the device and the heat sink;
wherein the carbon nanotubes disposed on the metal substrate are in conductive contact with the device and the heat sink.

5. The metal substrate of claim 1, wherein the carbon nanotubes are vertically aligned and oriented perpendicularly to the metal substrate.

## Patentansprüche

1. Metallsubstrat, das auf zwei gegenüberliegenden Seiten darauf abgeschiedene Kohlenstoffnanoröhren hat, wobei das Metallsubstrat einen oder mehrere Hohlräume enthält und aus Eisen, Nickel, Aluminium, Kobalt, Kupfer, Chrom, Gold und Kombinationen davon zusammengesetzt ist, **dadurch gekennzeichnet, dass** das Metallsubstrat einen Effektivwert der Rauheit von weniger als 250 µm hat.

2. Metallsubstrat nach Anspruch 1, wobei der eine Hohlraum oder die mehreren Hohlräume eine Öffnung, die das Metallsubstrat durchbricht, enthalten.

3. Verfahren zum Herstellen des Metallsubstrats nach Anspruch 1, enthaltend:
Ausbilden von einem oder mehreren Hohlräumen in dem Metallsubstrat; und
Ablagern von Kohlenstoffnanoröhren auf gegenüberliegenden Seiten des Metallsubstrats.

4. Vorrichtung, enthaltend:
eine Einrichtung;
eine Wärmesenke; und
das Metallsubstrat nach Anspruch 1, das zwischen der Einrichtung und der Wärmesenke angeordnet ist;
wobei die Kohlenstoffnanoröhren in wärmeleitendem Kontakt mit der Einrichtung und
der Wärmesenke sind.

5. Metallsubstrat nach Anspruch 1, wobei die Kohlenstoffnanoröhren vertikal ausgerichtet sind und senkrecht zu dem Metallsubstrat gerichtet sind.

## Revendications

1. Substrat métallique présentant des nanotubes de carbone disposés sur deux faces opposées du substrat, selon lequel le substrat métallique comporte une ou plusieurs cavités et se compose de fer, de nickel, d'aluminium, de cobalt, de cuivre, de chrome, d'or, et de combinaisons de ceux-ci, **caractérisé en ce que** le substrat métallique présente une rugosité exprimée en valeur moyenne quadratique inférieure à 250 pm.

2. Substrat métallique selon la revendication 1, selon lequel la ou les plusieurs cavités comprend une ouverture aperture traversant le substrat métallique.

3. Procédé de fabrication du substrat métallique selon la revendication 1, comprenant :
la formation d'une ou de plusieurs cavités dans le substrat métallique ; et
le dépôt de nanotubes de carbone sur des faces opposées du substrat métallique.

4. Équipement comprenant :
un dispositif ;
un puits de chaleur ; et
le substrat métallique selon la revendication 1 disposé entre le dispositif et le puits de chaleur ;
selon lequel les nanotubes de carbone disposés sur le substrat métallique se trouvent en contact conducteur avec le dispositif et le puits de chaleur.

5. Substrat métallique selon la revendication 1, selon lequel les nanotubes de carbone sont alignés verticalement et orientés perpendiculaires au substrat métallique.
